# EUROPEAN PATENT APPLICATION

(11) **EP 2 595 315 A1**
(43) Date of publication of application: **22.05.2013**
(21) Application number: 11189555.3
(22) Date of filing: 17.11.2011
(51) Int. Cl.: H03H 9/02, H03H 9/08, H03L 1/04

(54) **Ovenized system containing micro-electromechanical resonator**

(71) Applicant: IMEC, 3001 Leuven (BE)
(72) Inventor: Borremans, Jonathan, 2500 Lier (BE); Pertijs, Michiel, 2622 AT Delft (NL)
(74) Representative: Sarlet, Steven Renaat Irène

(57) **Abstract**

Device comprising an ovenized system containing a MEM resonator with mechanical supports forming heating resistances for heating the resonator body through Joules heating. A temperature control system controls the temperature of the resonator by driving an electrical current through the heating resistances. The internal voltage of the resonator body is monitored by means of a replica circuit comprising resistances in parallel over the heating resistances and replicating the resistance ratio thereof. A compensation means is connected to an intermediate connection of the replica circuit and compensates for deviations of the replicated voltage level at the intermediate connection from a predetermined voltage level.

## Description

### Technical field

The present invention relates to an electronic device comprising an ovenized system containing a micro-electromechanical resonator, and a temperature control system for controlling the temperature of the microelectromechanical resonator.

The present invention further relates to a method for controlling a micro-electromechanical resonator in an ovenized system.

### Background art

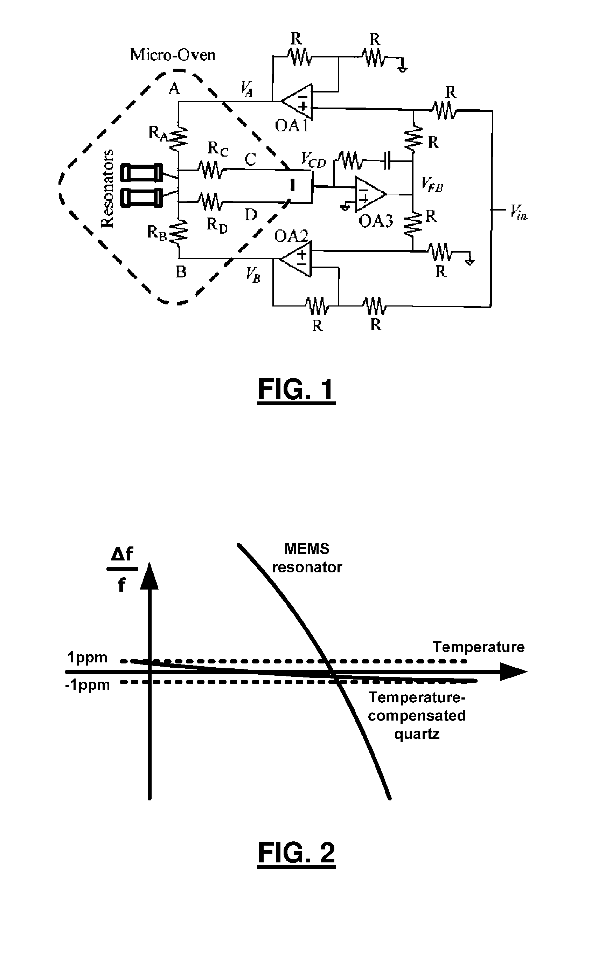

A temperature control system for a MEMS oscillator is known from James C. Salvia et al., "Real-Time Temperature Compensation of MEMS Oscillators Using an Integrated Micro-Oven and a Phase-Locked Loop", Journal Of Microelectromechanical Systems, Vol. 19, No. 1, February 2010. The circuit is shown in Fig. 1. Heating happens through mechanical supports R_{A} and R_{B}. A sensing point of the internal voltage of the MEMS oscillator is made to use a feedback loop to keep the internal voltage stable to a wanted value, with minor impact on the heating, through amplifier OA1 and OA2. For mechanical symmetry two sensing points R_{c} and R_{D} are made, since the sensing resistors are two additional support beams on the MEMS resonator. This circuit has the disadvantage that the addition of the mechanical connections to the MEMS device impacts the mechanical performance and adds paths for heat loss, which increases the power consumption.

Another method, Krishnakumar Sundaresan et al., "A Low Phase Noise 100MHz Silicon BAW Reference Oscillator", IEEE 2006 Custom Intergrated Circuits Conference (CICC), does not sense the internal voltage of the MEMS device, but uses a squaring function generator to compensate the theoretical bias voltage increase with heating power. This is not very accurate (the actual voltage is not sensed), comes with complicated squaring circuitry overhead, and the block consumes 170mW.

### Disclosure of the invention

It is an aim of the present invention to provide a device and method with which the internal voltage of a micro-electromechanical resonator in an ovenized system can be accurately monitored, while an impact on mechanical performance and heat loss can be avoided.

This aim is achieved according to the invention with a device and a method of the independent claims.

The invention provides an electronic device comprising an ovenized system containing a micro-electromechanical (MEM) resonator, the resonator comprising:
- a resonator body suspended above a substrate by means of at least a first and a second mechanical support forming a first and a second heating resistance for heating the resonator body through Joules heating;
- biasing means (e.g. comprising one or more electrodes) provided for applying a bias voltage to the resonator body to enable vibration at a predetermined operating frequency.

A temperature control system is provided for controlling the temperature of the micro-electromechanical resonator. By means of this temperature control system, the variation of the parameters of the MEM resonator over temperature can be counteracted by stabilizing the temperature of the MEM resonator. This is achieved in a power efficient way by the oven-controlled setup. The MEM resonator is warmed up in the micro-oven to a temperature above the ambient temperature, the temperature of the MEM resonator is monitored, and kept fixed, i.e. within a narrow, predetermined range of e.g. 0.10°C, which can for example be monitored by means of a temperature sensing means provided on or in the vicinity of the resonator body. Hence the MEM resonator is always at substantially the same temperature, and its parameters can be kept stable. According to the invention, the temperature control system comprises:
- current driving means (e.g. sourcing and/or sinking current source, voltage source, tunable resistance(s), or other) provided for driving an electrical current (e.g. DC) through the first and second heating resistances;
- control means, connected to the current driving means and provided for controlling the current driving means.

The current which is driven through the first and second heating resistances / mechanical supports result in respective voltage drops over the mechanical supports. Hence, the internal voltage level of the resonator body may vary, which affects the bias voltage, i.e. the voltage difference between the resonator body and the biasing means (e.g. electrode(s)). In general, the resonator bias voltage may change as a function of heating power. Typically power is a quadratic function of applied current, while bias voltage is a linear function of applied current. In order to be able to compensate for this variation, the device of the invention further comprises an internal voltage monitoring system, which comprises:
- a replica circuit comprising a third and a fourth resistance in parallel over the first and second heating resistances and replicating the resistance ratio of the first and second heating resistances, so that an intermediate connection between the third and fourth resistances replicates the voltage level of the resonator body;
- a compensation means connected to the intermediate connection between the third and fourth resistances and provided for compensating for deviations of the replicated voltage level at the intermediate connection from a predetermined voltage level.

With the internal voltage monitoring system of the device of the invention, the internal voltage of the resonator body can be monitored without the addition of any sensing nodes or connections to the resonator body. As a result, impact on the mechanical operation can be avoided and also the creation of additional paths for heat loss can be avoided.

The internal voltage monitoring system of the device of the invention senses an actual voltage level, which is a replica of the internal voltage level of the resonator body. As a result, a higher accuracy can be achieved with respect to a monitoring system on the basis of theoretical calculations.

In embodiments according to the invention, the compensation can be on the current which is driven through the first and second heating resistances. This can for example be achieved in that the compensation means comprises an additional current driving means (e.g. sourcing and/or sinking current source, voltage source, tunable resistance(s), or other), parallel over the current driving means of the temperature control system. Otherwise, this can for example be achieved by providing a feedback of the voltage level on the intermediate connection to the control means of the temperature control system.

For controlling the additional current driving means, the compensation means can comprise an additional control means, which is connected to an output of a comparator, a difference amplifier (e.g. an operational amplifier or an operational transconductance amplifier) or other evaluation block for comparing the voltage on the intermediate connection with a reference for the predetermined voltage level.

In embodiments according to the invention, the compensation can also be on the bias voltage which is applied to the resonator body. This can be achieved by adjusting the voltage supplied to the biasing means by the same amount as the deviation which is sensed by the compensation means. So in this case, the compensation means provide feedback to the biasing means.

The compensation on the currents is preferred over the compensation on the bias voltage, since the electrostatic actuator voltage supplied to the biasing means is typically a high voltage (e.g. at least 50 V, high with respect to solid-state technologies), which can be difficult to manipulate. However, the compensation on the bias voltage is to be considered inside the scope of the present invention.

In embodiments according to the invention, the third and fourth resistances can have very high resistance values with respect to the first and second resistances, e.g. at least 10 times higher, preferably at least 100 times higher, so that the third and fourth resistances conduct very little current and have very little impact on the current driven through the first and second resistances.

In embodiments according to the invention, the first and second mechanical supports can be part of a clamped-clamped beam, the resonator body being connected to the first and second mechanical supports by means of a connection part. The first and second mechanical supports can however also be individual support beams on which the resonator body is suspended. In this embodiment, the clamped-clamped beam with Joule heating, replica circuit, etc., is preferably provided on both sides of the resonator body for symmetry purposes.

In embodiments according to the invention, the first and second heating resistances have substantially the same resistance values. This is however not essential: the heating resistances can also have different values, resulting from for example different lengths of the mechanical supports.

### Brief description of the drawings

The invention will be further elucidated by means of the following description and the appended figures.
Figure 1 shows a prior art ovenized system containing a pair of MEM oscillators and a monitoring circuit for monitoring the internal voltage of the oscillators.
Figure 2 compares the temperature dependency of parameters of MEMS resonators to those of quartz resonators.
Figure 3 shows a schematic general overview of an electronic device according to the invention.
Figure 4 shows a perspective view of a MEM resonator which can be used in electronic devices according to the invention.
Figure 5 shows a top view of a MEM resonator which can be used in electronic devices according to the invention.
Figure 6 shows a first embodiment of a control circuit for controlling a MEM resonator according to the invention.
Figure 7 shows a second embodiment of a control circuit for controlling a MEM resonator according to the invention.
Figure 8 shows a third embodiment of a control circuit for controlling a MEM resonator according to the invention.
Figure 9 shows a fourth embodiment of a control circuit for controlling a MEM resonator according to the invention.
Figure 10 shows a possible implementation for the control circuit of Figure 9.
Figure 11 shows a measurement example achieved by means of the implementation of Figure 10.
Figure 12 shows a fifth embodiment of a control circuit for controlling a MEM resonator according to the invention.

### Modes for carrying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

As used herein, the term resonator encompasses all structures having or capable of having a desired, mechanical or electro-mechanical vibration. In the example that follows, a bar resonator is used. The invention is however not limited to resonant beams having rectangular cross sections. Other shapes (e.g. square, circular, parallelepiped, cube, etc.) are also possible within the scope of the invention.

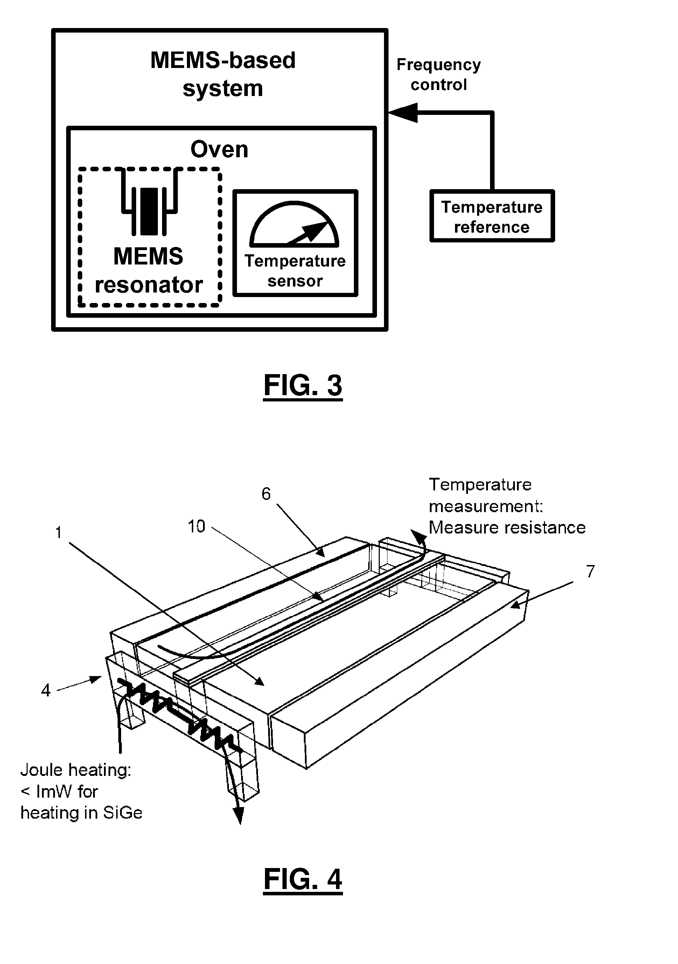

It is known that MEM resonator devices exhibit a higher variation of their parameters over temperature in comparison with quartz resonators (see Fig. 2), but MEM resonators are gaining interest in view of economic reasons. To solve the temperature variation of the parameters, a stabilization over the temperature is desired. One way of achieving this, is through an oven-controlled setup, see Fig. 3. A MEM device is placed in a micro-oven, warmed up (to a temperature above ambient, e.g. 70-90°C), and the temperature of the device is monitored and kept within a predefined narrow range (e.g. 0.10°C accurate or less). Hence the MEMS device is always at substantially the same temperature, and its parameters are substantially fixed, as desired.

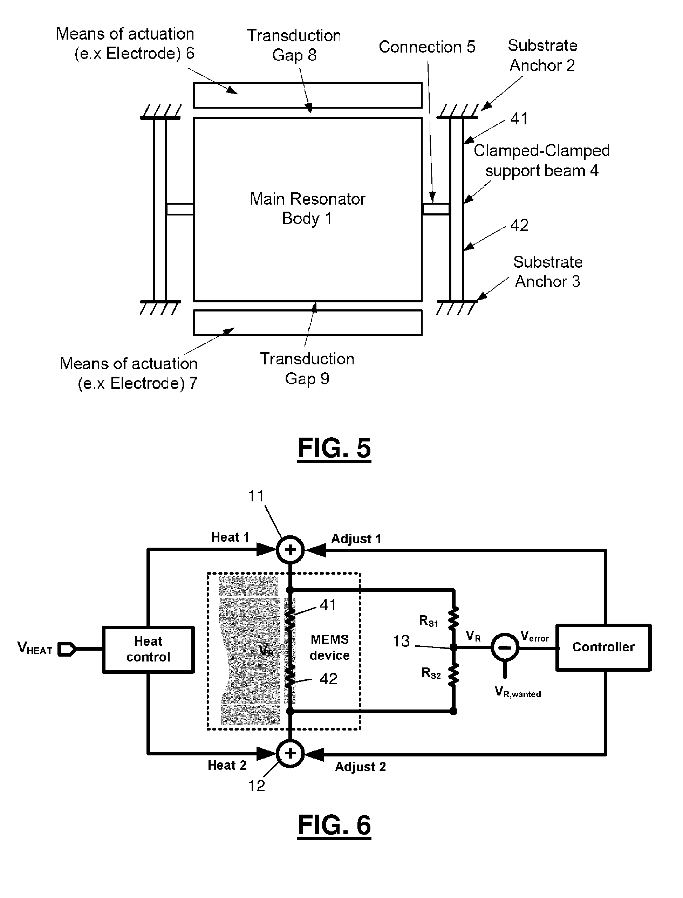

The MEM resonator device shown in Fig. 5 is a possible embodiment for an ovenized system according to the invention. It comprises a main resonating body 1, at least one means of actuation 6, 7 (e.g. electrode for applying a bias voltage) placed at close proximity, i.e. at a transduction gap 8, 9, to the main resonator body 1 and at least one T-shaped support 4 for anchoring the main resonator body to the substrate.

The T-shaped support or T-support comprises a clamped-clamped beam (further in the text "support" is also used) comprising two legs 41, 42 attached by means of anchors 2, 3 to the substrate, and a common, preferably central connection 5 to the main resonant body 1.

The MEM resonator device or structure is configured to resonate at least in a predetermined mode, for example a breathing mode. The main resonator body resonates at a resonance frequency (*fᵣₑₛ*) related to its natural response. The length of the clamped-clamped beams or support is chosen to be in relation to the flexural wavelength (type of wavelength dependent on most important stress component to support) for providing frequency stability and high Q factor. The T-support design utilizing a rigid clamped-clamped support provides electromechanical stability in the direction of actuation. More in particular, the length of each leg 41, 42 of the beam can be chosen as a multiple of half the flexural wavelength plus an offset term, i.e. acoustically long with respect to the flexural wavelength of the beam, which has the advantages of enhanced flexibility and minimizing heat losses towards the substrate. However, the T-shaped support is not essential; other support types can also be used within the scope of the invention, such as for example Y-shaped or single mechanical supports or other.

As shown in Figure 4, the T-shaped supports 4 can be used for heating the MEM resonator main body 1 to the operating temperature. Current is supplied to the T-shaped supports for achieving Joules heating. In order to control the current, the temperature of the main body is measured, for example by means of a resistance 10 on top of the resonator body 1. Using this principle in combination with the acoustically long leg design, power consumption for heating can be reduced to below 1 mW.

The heating current through the support 4 of the device results in a resistive voltage drop *V_{R}* over each mechanical support 41, 42. Hence, the bar center voltage changes. As a consequence, in general, the resonator bias voltage may change as a function of heating power. The latter in its turn is a function of ambient temperature. The higher the ambient temperature, the lower the required heating power to stabilize the resonator, the lower the current i and the lower the voltage drop *V_{R}.* The MEMS resonance parameters are partly determined by the bias voltage: in the case of Figure 4 and 5 the bias voltage is the voltage difference between the electrostatic actuation 6, 7 and the resonator body 1.

As a consequence, the electrostatic bias voltage may change over temperature. On the other hand, the MEMS resonance frequency is also a function of the resonator bias voltage. Therefore, the frequency is dependent on temperature, not only through heating (wanted), but also through the bias change (which is unwanted) even though the temperature of the resonator is kept stable.

In order to resolve this unwanted variation of the temperature, i.e. to stabilize the centre voltage level of the resonator body 1 at a predetermined level, the voltage level of the resonator body is monitored according to the invention by means of a replica circuit and a compensation mechanism, embodiments of which are explained below.

A first embodiment of the invention is depicted in Figure 6. Current is driven by means of a sourcing current (or voltage) source 11 and a sinking current (or voltage) source 12 through the mechanical supports 41, 42 for heating the resonator body 1 by Joule heating. The sourcing current source 11 and the sinking current source 12 are initially set to supply currents of equal value, and equal to the target value required for heating the MEM resonator to the desired temperature. Voltage *v_{R}'of* the resonator body is then sensed by means of a replica circuit, comprising a set of sensing resistors R_{S1} and R_{S2} in parallel over the heating circuit formed by heating resistors 41, 42. These sensing resistors can be of very high value (e.g. at least 10 times or at least 100 times higher than the heating resistances), to not impact the heating mechanism and conduct almost no current. Resistors R_{S1} and R_{S2} are chosen to replicate the resistance ratio of the heating resistors 41, 42, so that the centre 13 between the resistors provides an emulated copy *v_{R}* of the real internal voltage *V_{R}'.* The replica voltage *v_{R}* at the centre 13 between the sensing resistors R_{S1} and R_{S2} is compared with a predetermined voltage V*_{R,wanted}.* The resulting error signal *Vₑᵣᵣₒᵣ* is fed into a controller for adjusting the current driven by either the sourcing current (or voltage) source 11 or the sinking current (or voltage) source 12, such that the replica voltage *v_{R},* and thus the real internal voltage *V_{R}'* are adjusted towards the predetermined voltage *V_{R,wanted}.* The feedback loop runs continually, adjusting automatically when the required heater power is changed. The bias voltage of the MEM resonator can hence be kept stable.

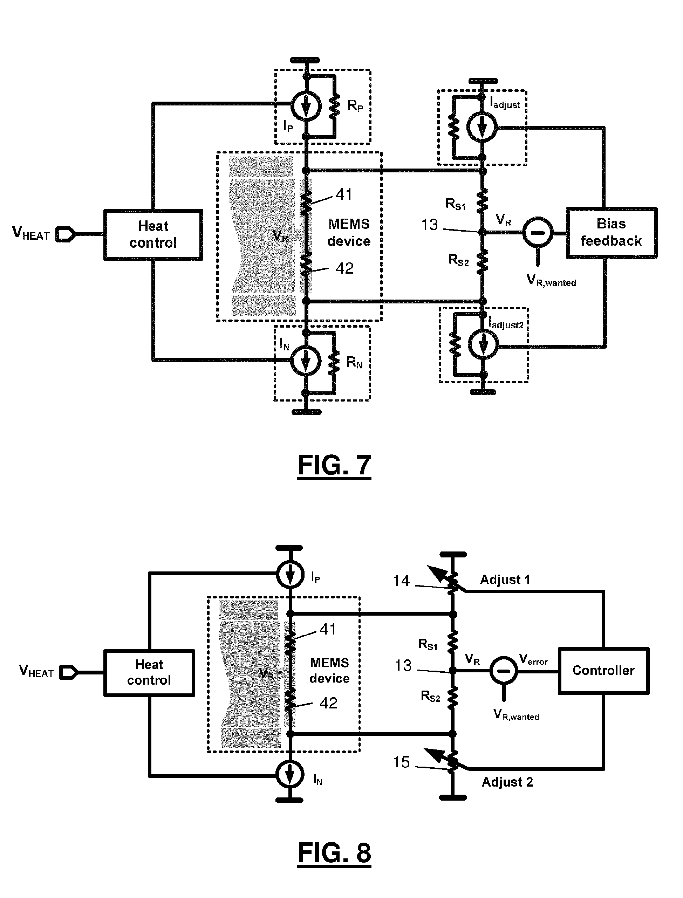

A second embodiment of the invention is depicted in Figure 7. The main current for driving the heating resistances 41, 42 is supplied by means of a positive and negative current source I_{P} and I_{N}. In parallel, a positive adjustment current source I_{ADJUST} and a negative adjustment current source I_{ADJUST2} are provided, controlled by the controller of the bias compensation circuit. The excess current will flow in the output impedance of the current sources (e.g. R_{P} or R_{N}). The bias compensation circuit is otherwise the same as the one of figure 6.

A third embodiment is depicted in Figure 8. Here, the adjustment currents are generated by means of tunable resistors, controlled by the controller of the bias compensation circuit. The bias compensation circuit is otherwise the same as the one of figure 6.

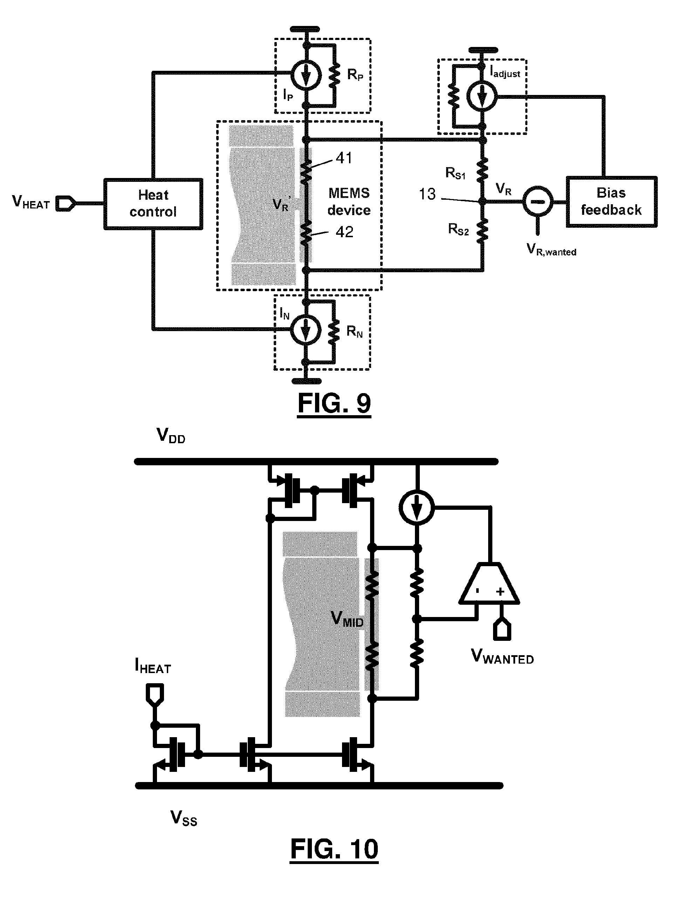

A fourth embodiment is depicted in Figure 9. Here, there is only the positive adjustment current source, controlled by the controller of the bias compensation circuit.

Figure 10 shows a practical implementation of the embodiment of Figure 9. A current input I_{HEAT} sets the wanted heating current by means of a current mirror to a sourcing current source (PMOS, top) and sinking current source (NMOS, bottom), pushing the current through the mechanical support of the resonator (100s of Ohms), producing a center voltage V_{MID}. Two very large (100s of kOhms) sense resistors (external of the MEMS resonator) copy the voltage V_{MID}. A feedback loop drives V_{MID} to be equal to V_{WANTED}, regardless of the wanted heater power set by I_{HEAT}, thanks to a feedback current source.

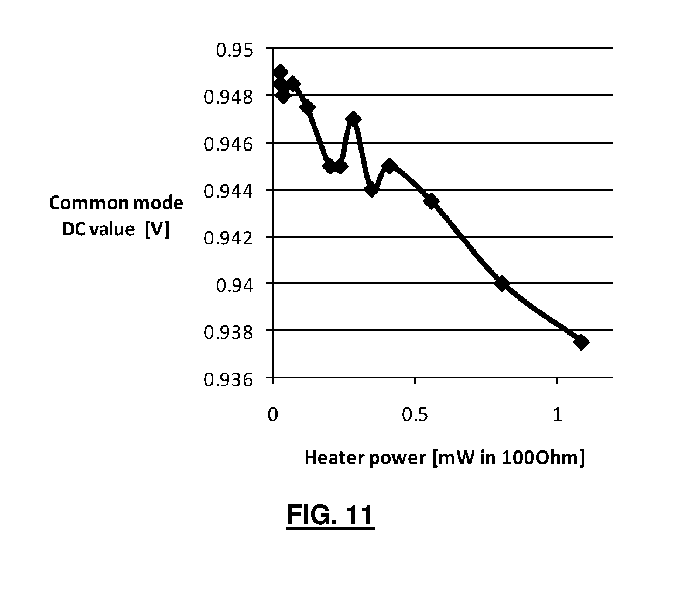

A measurement example is given in Figure 11, showing that *V_{R}* (referred to as 'Common mode DC value'), stays stable up to ~10mV over the whole targeted heater power range of 0-1 mW.

In figures 6-10, the controller of the temperature control circuit and the controller of the bias compensation circuit are shown as separate controllers. These can however also be combined into a single controller. The controller(s) can be a combination of analog components and/or a digital controller.

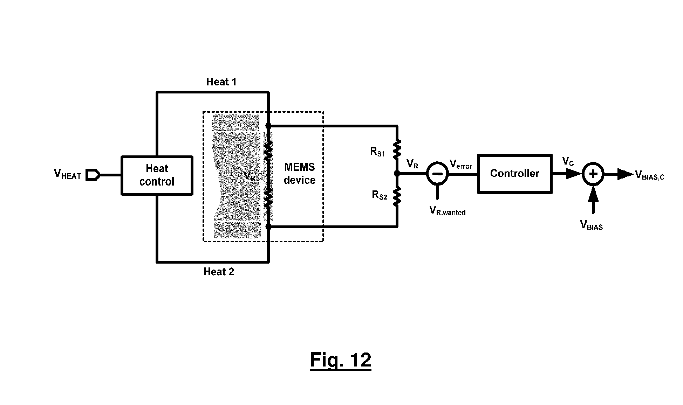

In alternative embodiments (see Fig. 12), one could increase (or decrease) the electrostatic bias voltage (on the electrodes 6, 7) with the same amount as the voltage drop *V_{R},* in an open-loop configuration, to counteract the bias voltage variation. This is however more difficult to achieve, since typically the electrostatic actuator voltage is a high voltage (e.g. 50V, high with respect to solid-state technologies) - though not impossible.

## Claims

1. Electronic device comprising
an ovenized system containing a micro-electromechanical resonator, the resonator comprising:
- a resonator body (1) suspended above a substrate by means of at least a first and a second mechanical support (41, 42) forming a first and a second heating resistance for heating the resonator body through Joules heating;
- biasing means (6, 7) provided for applying a bias voltage to the resonator body to enable vibration at a predetermined operating frequency;
a temperature control system for controlling the temperature of the microelectromechanical resonator, the temperature control system comprising:
- current driving means (11, 12) for driving an electrical current through the first and second heating resistances;
- control means for controlling the current driving means;
and an internal voltage monitoring system for monitoring the voltage level of the resonator body, **characterised in that** the internal voltage monitoring system comprises:
- a replica circuit comprising a third and a fourth resistance (R_{S1} and R_{S2}) in parallel over the first and second heating resistances and replicating the resistance ratio of the first and second heating resistances, so that an intermediate connection (13) between the third and fourth resistances replicates the voltage level of the resonator body;
- a compensation means connected to the intermediate connection (13) between the third and fourth resistances and provided for compensating for deviations of the replicated voltage level (*V_{R}*) at the intermediate connection from a predetermined voltage level (*V_{R,wanted}*)*.*

2. Electronic device according to claim 1, wherein the compensation means is provided for adjusting the electrical current which is driven through the first and second heating resistances, such that the voltage level (*V_{R}*) of the intermediate connection is adjusted towards the predetermined voltage level (*V_{R,wanted}*)*.*

3. Electronic device according to claim 2, wherein the compensation means comprises a comparator of which one input node is connected to the intermediate connection (13) and another input node is connected to a means for supplying the predetermined voltage level (*V_{R,wanted}*)*,* an additional current driving means (I_{ADJUST}, I_{ADJUST2}) parallel over the current driving means (I_{P}, I_{N}) of the temperature control system, and an additional control means connected to the comparator and the additional current driving means and provided for controlling the additional current driving means based on the output of the comparator.

4. Electronic device according to claim 2, wherein the compensation means comprises a difference amplifier of which one input node is connected to the intermediate connection (13) and another input node is connected to a means for supplying the predetermined voltage level (*V_{R,wanted}*)*,* an additional current driving means (I_{ADJUST}, I_{ADJUST2}) parallel over the current driving means (I_{P}, I_{N}) of the temperature control system, and an additional control means connected to the difference amplifier and the additional current driving means and provided for controlling the additional current driving means based on the output of the difference amplifier.

5. Electronic device according to claim 2, wherein the compensation means comprises a feedback of the voltage level (*V_{R}*) on the intermediate connection (13) to the control means of the temperature control system.

6. Electronic device according to any one of the previous claims, wherein the current driving means comprise a sourcing current source (I_{P}) connected to the first heating resistance (41) and a sinking current source (I_{N}) connected to the second heating resistance (42).

7. Electronic device according to claim 6, wherein the compensation means comprises an additional sourcing current source (I_{ADJUST}) parallel over the sourcing current source (I_{P}) and/or an additional sinking current source (I_{ADJUST2}) parallel over the sinking current source (I_{N}).

8. Electronic device according to claim 6, wherein the compensation means comprises a first variable resistance (14) parallel over the sourcing current source (I_{P}) and/or a second variable resistance (15) parallel over the sinking current source (I_{N}).

9. Electronic device according to claim 1, wherein the compensation means are provided for adjusting the voltage supplied to the biasing means (6, 7), such that the voltage supplied to the biasing means is adjusted by the same amount as the deviation of the replicated voltage level at the intermediate connection from the predetermined voltage level.

10. Electronic device according to any one of the previous claims, wherein the third and fourth resistances (R_{S1} and R_{S2}) have very high resistance values with respect to the first and second resistances (41, 42).

11. Electronic device according to any one of the previous claims, wherein the first and second mechanical supports (41, 42) are part of a clamped-clamped beam (4), the resonator body (1) being connected to the first and second mechanical supports by means of a connection part (5).

12. Electronic device according to any one of the previous claims, wherein the first and second heating resistances (41, 42) have substantially the same resistance values.

13. Method for controlling a micro-electromechanical resonator in an ovenized system, the resonator comprising a resonator body (1) suspended above a substrate by means of at least a first and a second mechanical support (41, 42) forming a first and a second heating resistance for heating the resonator body through Joules heating, the method comprising the steps of:
- applying a bias voltage to the resonator body to enable vibration at a predetermined operating frequency;
- controlling the temperature of the micro-electromechanical resonator by means of a the temperature control system in which a current driving means (11, 12) drives an electrical current through the first and second heating resistances (41, 42), and a control means controls the current driving means; and
- monitoring the voltage level of the resonator body by means of an internal voltage monitoring system;
**characterised in that** the step of monitoring the voltage level of the resonator body comprises:
- replicating the voltage level of the resonator body by means of a replica circuit comprising a third and a fourth resistance (R_{S1} and R_{S2}) in parallel over the first and second heating resistances and replicating the resistance ratio of the first and second heating resistances, such that an intermediate connection (13) between the third and fourth resistances is at a replicated voltage level (*V_{R}*);
- compensating for deviations of the replicated voltage level (*V_{R}*) at the intermediate connection from a predetermined voltage level (*V_{R,wanted}*)*.*

14. Method according to claim 13, wherein the compensation comprises adjusting the electrical current which is driven through the first and second heating resistances, such that the replicated voltage level (*V_{R}*) of the intermediate connection is adjusted towards the predetermined voltage level (*V_{R,wanted}*).

15. Method according to claim 13, wherein the compensation comprises adjusting the voltage supplied to the biasing means by the same amount as the deviation of the replicated voltage level at the intermediate connection from the predetermined voltage level.

## Amended claims

### Amended claims in accordance with Rule 137(2) EPC.

**1.** Electronic device comprising an ovenized system containing a micro-electromechanical resonator, the resonator comprising:
- a resonator body (1) suspended above a substrate by means of a support comprising at least a first and a second mechanical support (41, 42) forming a first and a second heating resistance for heating the resonator body through Joules heating wherein the first and second mechanical support (41, 42) are attached by means of a common connection (5) to the resonator body (1);
- biasing means (6, 7) provided for applying a bias voltage to the resonator body to enable vibration at a predetermined operating frequency;
a temperature control system for controlling the temperature of the micro-electromechanical resonator, the temperature control system comprising:
- current driving means (11, 12) for driving an electrical current through the first and second heating resistances;
- control means for controlling the current driving means;
and an internal voltage monitoring system for monitoring the voltage level of the resonator body, **characterised in that** the internal voltage monitoring system comprises:
- a replica circuit comprising a third and a fourth resistance (R_{S1} and R_{S2}) in parallel over the first and second heating resistances and replicating the resistance ratio of the first and second heating resistances, so that an intermediate connection (13) between the third and fourth resistances replicates the voltage level of the resonator body;
- a compensation means connected to the intermediate connection (13) between the third and fourth resistances and provided for compensating for deviations of the replicated voltage level (*v_{R}*) at the intermediate connection from a predetermined voltage level (*v_{R},_{wanted}*),
**characterized in that** the compensation means comprise a comparator of which one input node is connected to the intermediate connection (13) and another input node is connected to a means for supplying the predetermined voltage level (*V_{R,wanted}*)*.*

**2.** Electronic device according to claim 1, wherein the compensation means is provided for adjusting the electrical current which is driven through the first and second heating resistances, such that the voltage level (*v_{R}*) of the intermediate connection is adjusted towards the predetermined voltage level (*V_{R,wanted}*)*.*

**3.** Electronic device according to claim 2, wherein the compensation means comprises an additional current driving means (I_{ADJUST}, I_{ADJUST2}) parallel over the current driving means (I_{P}, I_{N}) of the temperature control system, and an additional control means connected to the comparator and the additional current driving means and provided for controlling the additional current driving means based on the output of the comparator.

**4.** Electronic device according to claim 2, wherein the compensation means comprises a difference amplifier of which one input node is connected to the intermediate connection (13) and another input node is connected to a means for supplying the predetermined voltage level (*v_{R,wanted}*), an additional current driving means (I_{ADJUST}, I_{ADJUST2}) parallel over the current driving means (I_{P}, I_{N}) of the temperature control system, and an additional control means connected to the difference amplifier and the additional current driving means and provided for controlling the additional current driving means based on the output of the difference amplifier.

**5.** Electronic device according to claim 2, wherein the compensation means comprises a feedback of the voltage level (*v_{R}*) on the intermediate connection (13) to the control means of the temperature control system.

**6.** Electronic device according to any one of the previous claims, wherein the current driving means comprise a sourcing current source (I_{P}) connected to the first heating resistance (41) and a sinking current source (I_{N}) connected to the second heating resistance (42).

**7.** Electronic device according to claim 6, wherein the compensation means comprises an additional sourcing current source (I_{ADJUST}) parallel over the sourcing current source (I_{P}) and/or an additional sinking current source (I_{ADJUST2}) parallel over the sinking current source (I_{N}).

**8.** Electronic device according to claim 6, wherein the compensation means comprises a first variable resistance (14) parallel over the sourcing current source (I_{P}) and/or a second variable resistance (15) parallel over the sinking current source (I_{N}).

**9.** Electronic device according to claim 1, wherein the compensation means are provided for adjusting the voltage supplied to the biasing means (6, 7), such that the voltage supplied to the biasing means is adjusted by the same amount as the deviation of the replicated voltage level at the intermediate connection from the predetermined voltage level.

**10.** Electronic device according to any one of the previous claims, wherein the third and fourth resistances (R_{S1} and R_{S2}) have very high resistance values with respect to the first and second resistances (41, 42).

**11.** Electronic device according to any one of the previous claims, wherein the first and second mechanical supports (41, 42) are part of a clamped-clamped beam (4), the resonator body (1) being connected to the first and second mechanical supports by means of a connection part (5).

**12.** Electronic device according to any one of the previous claims, wherein the first and second heating resistances (41, 42) have substantially the same resistance values.

**13.** Method for controlling a micro-electromechanical resonator in an ovenized system, the resonator comprising a resonator body (1) suspended above a substrate by means of a support comprising at least a first and a second mechanical support (41, 42) forming a first and a second heating resistance for heating the resonator body through Joules heating, wherein the first and second mechanical support (41, 42) are attached by means of a common connection (5) to the resonator body (1), the method comprising the steps of:
- applying a bias voltage to the resonator body to enable vibration at a predetermined operating frequency;
- controlling the temperature of the micro-electromechanical resonator by means of a the temperature control system in which a current driving means (11, 12) drives an electrical current through the first and second heating resistances (41, 42), and a control means controls the current driving means; and
- monitoring the voltage level of the resonator body by means of an internal voltage monitoring system;
wherein the step of monitoring the voltage level of the resonator body comprises:
- replicating the voltage level of the resonator body by means of a replica circuit comprising a third and a fourth resistance (R_{S1} and R_{S2}) in parallel over the first and second heating resistances and replicating the resistance ratio of the first and second heating resistances, such that an intermediate connection (13) between the third and fourth resistances is at a replicated voltage level (*v_{R}*);
- compensating for deviations of the replicated voltage level (*v_{R}*) at the intermediate connection from a predetermined voltage level (*V_{R,wanted}*) by means of a compensation means;
**characterized in that** the compensation means comprises a comparator of which one input node is connected to the intermediate connection (13) and another input node is connected to a means for supplying the predetermined voltage level (*V_{R,wanted}*)*.*

**14.** Method according to claim 13, wherein the compensation comprises adjusting the electrical current which is driven through the first and second heating resistances, such that the replicated voltage level (*v_{R}*) of the intermediate connection is adjusted towards the predetermined voltage level (*V_{R,wanted}*).

**15.** Method according to claim 13, wherein the compensation comprises adjusting the voltage supplied to the biasing means by the same amount as the deviation of the replicated voltage level at the intermediate connection from the predetermined voltage level.
